# EUROPEAN PATENT APPLICATION

(11) **EP 4 741 750 A1**
(43) Date of publication of application: **13.05.2026**
(21) Application number: 25210285.0
(22) Date of filing: 22.10.2025
(51) Int. Cl.: F28D 1/053, F28F 1/42, F28F 13/12

(54) **DIMPLE TUBULAR HEAT EXCHANGER USED FOR APU**

(30) Priority: 07.11.2024 US 202463717652 P; 14.10.2025 US 202519357558
(71) Applicant: Honeywell International Inc., Charlotte, NC 28202 (US)
(72) Inventor: ZHOU, Ding-Wei, Charlotte 28202 (US); DO, Quang, Charlotte 28202 (US)
(74) Representative: Haseltine Lake Kempner LLP

(57) **Abstract**

A heat exchanger includes a microtube defining a lumen and including a plurality of dimples configured to cause a turbulent flow of a fluid within the lumen of the microtube. The microtube has an outer diameter equal to or less than 5 mm.

## Description

This application claims the benefit of U.S. Provisional Patent Application No. 63/717,652, filed 7 November 2024, the entire contents of which is incorporated herein by reference.

### TECHNICAL FIELD

The present disclosure relates to heat exchangers.

### BACKGROUND

A heat exchanger may be positioned within fluid streams of a fluid handling system, or in the exhaust gases of a process, in order to transfer heat between the fluids and/or gases. The efficiency of a heat exchanger depends at least in part on the heat transfer coefficients between the fluids and/or gases.

### SUMMARY

In some examples, this disclosure describes a heat exchanger comprising: a microtube defining a lumen and including a plurality of dimples configured to cause a turbulent flow of a fluid within the lumen of the microtube, wherein the microtube has an outer diameter equal to or less than 5 millimeters (mm).

In some examples, this disclosure describes a method of making a microtube, the method comprising: printing a microtube defining a lumen, the microtube comprising an inner surface and an outer surface; and printing a plurality of dimples in the inner surface of the microtube, each dimple of the plurality of dimples being configured to cause a turbulent flow of a fluid within the lumen of the microtube, and wherein an outer diameter of the microtube is equal to or less than 5 millimeters (mm).

The details of one or more examples are set forth in the accompanying drawings and the description below. Other features, objects, and advantages will be apparent from the description and drawings, and from the claims.

### BRIEF DESCRIPTION OF THE DRAWINGS

The details of one or more examples are set forth in the accompanying drawings and the description below. Other features, objects, and advantages will be apparent from the description and drawings, and from the claims.
FIG. 1 is a perspective view illustrating an example heat exchanger, in accordance with examples of the present disclosure.
FIG. 2 is a cross-sectional side view of an example dimpled tube for use with a heat exchanger, in accordance with examples of the present disclosure.
FIG. 3 is a cross-sectional side view of an example dimpled tube for use with a heat exchanger, in accordance with examples of the present disclosure.
FIG. 4 is a cross-sectional side view of an example dimpled tube for use with a heat exchanger, in accordance with examples of the present disclosure.
FIG. 5 is a cross-sectional longitudinal view of an example dimpled tube for use with a heat exchanger, in accordance with examples of the present disclosure.
FIG. 6 is a cross-sectional side view of an example non-dimpled microtube with a first fluid flowing through the non-dimpled microtube and a second fluid surrounding the tube.
FIG. 7 is a cross-sectional side view of an example dimpled microtube with a first fluid flowing through the dimpled microtube and a second fluid surrounding the microtube, in examples with examples of the present disclosure.
FIG. 8 is a cross-sectional side view of an example dimpled microtube for use with a heat exchanger, in accordance with examples of the present disclosure.
FIG. 9 is a flowchart of an example method of exchanging heat via heat exchanger, in accordance with examples of the present disclosure.

### DETAILED DESCRIPTION

This disclosure relates to a heat exchanger including one or more dimpled tubes. In some examples, the heat exchanger includes a plurality of dimpled tubes, and the tubes may be microtubes, e.g., each tube having an outer diameter that is equal to or less than about 5 millimeters (mm), or equal to or less than about 3 mm. In some examples, the heat exchanger is configured to transfer heat from a first fluid (e.g., cool the first fluid) to a second fluid. The first and second fluids may each be a liquid, a gas, an oil, a vapor, and/or a liquid/gas mixture. In some examples, the first fluid may be a gas, and the second fluid may be air.

In accordance with aspects of this disclosure, a heat exchanger includes dimpled microtubes configured to increase turbulent flow of a liquid within the tube. The turbulent flow may increase the heat transfer coefficient between the fluid within the tube and a fluid external to the tube with a decreased pressure drop penalty. For example, the turbulent flow may disturb or break up a boundary layer of the fluid relatively near the tube wall and away from the central portion of the tube. The turbulent flow may also increase mixing of the fluid within the tube, e.g., cause fluid near the tube wall to mix with fluid near the central portion of the tube. Disturbing and/or breaking up the boundary layer and mixing of the fluid within the tube may increase the heat flux transferred between the fluid internal to the tube and the fluid external to the tube, e.g., through the tube wall.

For example, the temperature difference may be greater between the two fluids because of the breaking up of the boundary layer and mixing of the fluid within the tube, e.g., the fluid near the tube wall that has transferred at least a portion of its heat at a first longitudinal position along the tube and is therefore closer to an equilibrium temperature with the external fluid is forced away from the tube wall at a second longitudinal position further along the tube and is replaced by fluid that was more central within the tube and further from the equilibrium temperature with the external fluid such that there is a greater temperature difference between the internal and external fluids, thereby increasing the heat transfer, or heat flux, between the internal and external fluids for the longitudinal length of tube between the first and second longitudinal positions.

In some examples, the increase in heat transfer/flux per tube length increases the heat transfer coefficient of the dimpled tube, e.g., relative to a similar non-dimpled tube. In some examples, the dimpled tube also increases the heat transfer coefficient by increasing the total surface area of the tube wall per length of tube, e.g., via the dimples. In some examples, the dimpled tube also increases the heat transfer coefficient by increasing turbulent flow external to the tube, e.g., the dimpled tube may disturb or break up a fluid boundary layer of the external fluid in the same manner as the internal fluid, thereby increasing the heat transfer/flux due to an increased temperature difference between the internal fluid and the external fluid, thereby increasing the heat transfer coefficient of the dimpled tube.

In some examples, the heat exchanger may include a plurality of dimpled tubes comprising microtubes that are relatively closely packed. For example, to improve the heat transfer between the first and second fluids without substantially increasing the pressure drop of the second (external) fluid, the tubes may be microtubes that are closely packed so as to increase the overall surface area per unit volume that the second (external) fluid contacts. The microtubes may each have an outer diameter that is equal to or less than about 5 mm, or equal to or less than about 3 mm, and may have a maximum spacing (e.g., between external surfaces of tube walls) that are equal to or less than about 5 mm, or equal to or less than about 3 mm.

Dimpling microtubes may be a challenge. Tubes may be formed by casting, and dimpling the tubes may be done via a post-casting process, e.g., depressing the outer surface of the tube. Dimpling microtubes via a post-casting depression process may crush the microtube because of the small diameter of the tube and the thinness of the tube wall. For example, even if proportionally scaled down from a conventional tube to keep the same proportion of wall thickness to tube diameter, and proportionately scaling down the pressure of the depression process, the stiffness of the tube walls of the proportionately scaled microtube may be exponentially less.

The stiffness of a material generally is proportionate to the thickness of the material to the third power, e.g., stiffness ∝ t³ where t is the material thickness, and the stiffness of microtube walls may decrease exponentially relative to typically sized tubes such that it becomes difficult to dimple a microtube without crushing (e.g., blocking the lumen defined by the tube) or cracking the tube wall. Dimpling processes may use pressures that are also exponentially decreased, however, maintaining consistent, relatively low pressures over small microtube areas may be difficult and dimpling errors and/or crushing of the tubes may increase. In accordance with aspects of this disclosure, a heat exchanger includes dimpled microtubes formed via a process robust to crushing or cracking the microtubes. In some examples, microtubes may be formed with dimples, e.g., via a printing process.

The plurality of dimples may be arranged on the microtube in a suitable way. For example, it may be desirable to increase turbulent flow of the fluid within the microtube while simultaneously minimizing an increase in a pressure drop along the microtube. In some examples, to achieve these disparate goals, the plurality of dimples may be uniformly distributed along a length of the microtube. For example, the plurality of dimples may include a first dimple, a second dimple, and a third dimple. The first dimple may be displaced from the second dimple by a first axial distance, and the second dimple may be displaced from the third dimple by a second axial distance. The first axial distance may be equal to the second axial distance. In some instances, the first axial distance may be in a range of from 0.5 mm to 5 mm. In other examples, the plurality of dimples may be randomly-distributed along a length of the microtube.

The plurality of microtubes may be similarly arranged about a perimeter (e.g., a circumference in examples where the microtube defines a substantially circular cross-section) of the microtube to increase turbulent flow and mixing within the microtube without unnecessarily increasing a pressure drop of a fluid flowing within the microtube. For example, the microtube may define a substantially circular outer perimeter. The first dimple may be displaced from the second dimple by a first angle, and the second dimple may be displaced from the third dimple by a second angle. The first angle may be equal to the second angle. In some instances, the first angle may be in a range of from about 5° to about 180°, such as from about 10° to about 90°. In other examples, the plurality of dimples may be randomly-distributed about a perimeter of the microtube.

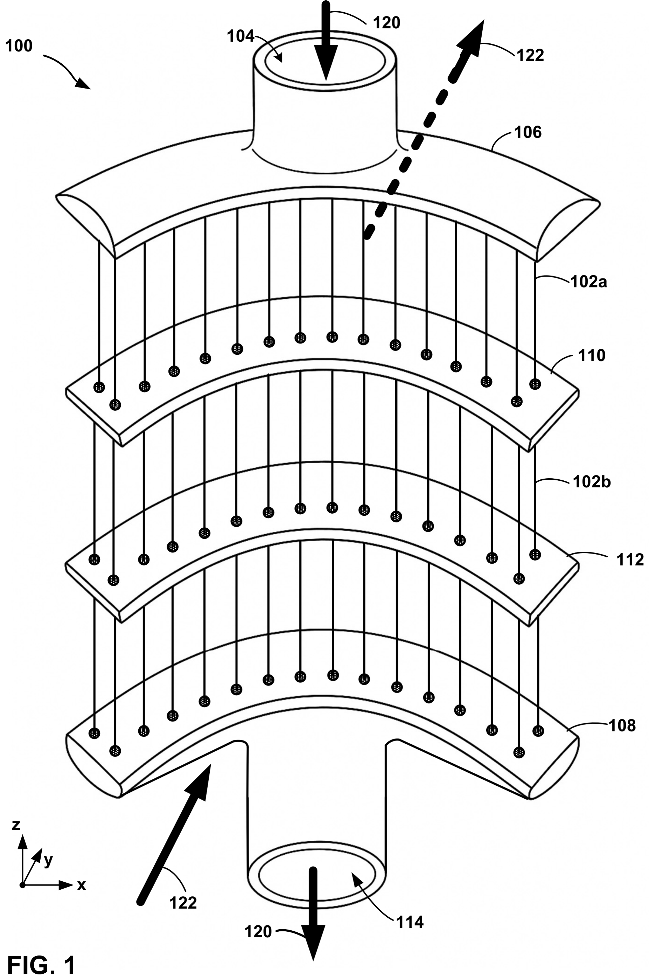

FIG. 1 is a perspective view of a schematic diagram illustrating an example heat exchanger 100 including dimpled microtubes 102, in accordance with examples of the present disclosure. In the example shown, heat exchanger 100 includes first microtube 102a, second microtube 102b, inlet 104, inlet frame 106, support frames 110, 112, outlet 114, and outlet frame 108.

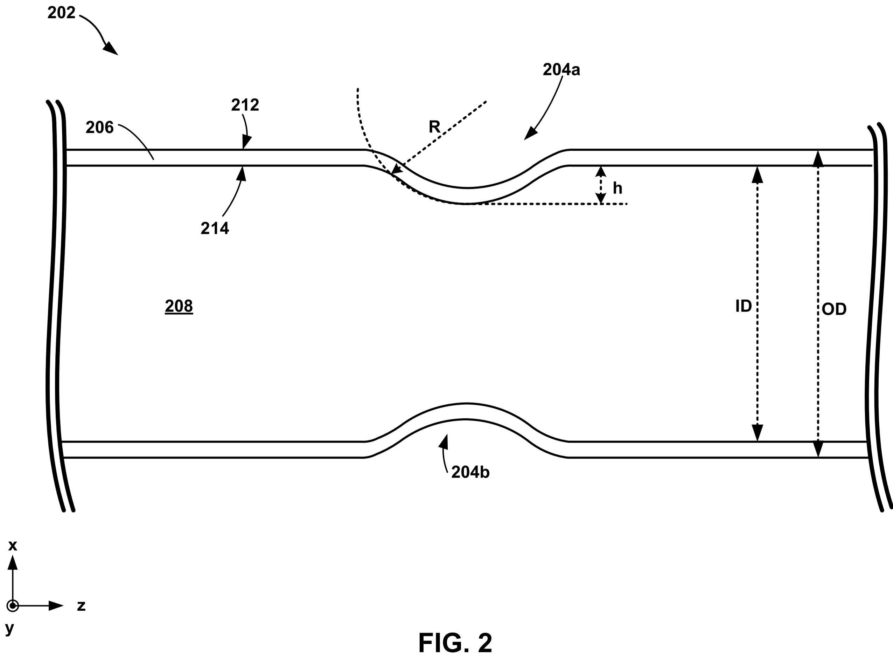

In some examples, heat exchanger 100 may include more or fewer than two microtubes 102a, 102b (collectively, "microtubes 102), e.g., one microtube 102 or three or more microtubes 102. In the example shown, heat exchanger 100 includes a plurality of microtubes 102. Heat exchanger 100 may be configured to have a spacing between respective outer surface of adjacent microtubes of 10 mm or less, or 5 mm or less, or 3 mm or less, or 1 mm or less, or any suitable spacing such that heat transfer between fluid 120 (inside microtubes 102) and fluid 122 (outside of microtubes 102) is increased (or the thermal coefficient of heat exchanger 100 or microtubes 102 is improved) relative to a non-microtube heat exchanger and without a significant pressure drop increase of fluid 122. In some examples, heat exchanger 100 is configured to allow fluid 122 to flow in contact with an external surface (e.g., outer surface 212 of FIG. 2) of one or more of microtubes 102.

Each microtube 102 may include a tube wall defining a lumen, and the lumen of each microtube 102 may be fluidically connected to inlet 104 and outlet 114. The tube wall may have an inner surface and an outer surface (e.g., external to the tube), and one or both of the inner and outer surfaces may include a dimple, e.g., a surface height variation of the inner or outer surface, or one or both of the inner and outer surfaces may include a plurality of dimples. In some examples, the dimple(s) of microtubes 102 may be configured to cause a turbulent flow of a fluid within each respective lumen of each respective microtube 102, e.g., for inner surface dimples, or to cause a turbulent flow of a fluid adjacent to or contacting the outer surface of each respective microtube 102, e.g., for outer surface dimples.

In the example shown, heat exchanger 100 includes inlet frame 106 defining inlet 104 and outlet frame 108 defining outlet 114. Inlet frame 106 and outlet frame 108 may be configured to support and/or mechanically attach to microtubes 102. Heat exchanger 100 may optionally include support frames 110, 112. Support frames 110, 112 may be configured to further support microtubes 102, e.g., against a pressure drop from fluid 122. In the example shown, inlet 104 is configured to receive fluid 120, which may be a liquid, a gas, an oil, a vapor, and/or a liquid/gas mixture, and route fluid 120 to the lumens of the plurality of microtubes, and then to outlet 114. Heat exchanger 100 may also include an inlet for fluid 122, and may be configured to route fluid 122 to an outlet after passing through, e.g., adjacent to or in contact with, the plurality of microtubes 102. In some examples, fluid 120 may be an oil and fluid 122 may be air, and heat exchanger 100 is configured to cool the oil fluid 120 via heat transfer to the air fluid 122. In some examples, heat exchanger 100 may be configured to be used with a motor, a generator, an engine, or a power unit such as an auxiliary power unit (APU), or any suitable device.

FIG. 2 is a cross-sectional diagram illustrating an example microtube 202 including a first dimple 204a and a second dimple 204b, in accordance with examples of the present disclosure. In the example shown, microtube 202 includes tube wall 206 defining lumen 208. Microtube 202 may be an example of microtubes 102 of FIG. 1.

Tube wall 206 may include an inner surface 214 and an outer surface 212. In some examples, microtube 202 may include first dimple 204a as a surface height variation of both the inner surface 214 and the outer surface 212, e.g., as shown in FIG. 2. In other examples, microtube 202 may include first dimple 204a as a surface height variation of just inner surface 214, or of just outer surface 212.

In the example shown, first dimple 204a is a recess in outer surface 212 and a protrusion into lumen 208 from inner surface 214. In other examples, first dimple 204a may be a recess in just outer surface 212 or just a protrusion from outer surface 212, or first dimple 204a may be just a protrusion into lumen 208 from inner surface 214 or just a recess into tube wall 206 from inner surface 214, or first dimple 204a may be a recess into tube wall 206 from inner surface 214 and a protrusion from outer surface 212, or protrusion from outer surface 212 and a protrusion into lumen 208 from inner surface 214, or a recess into tube wall 206 from inner surface 214 and a recess in outer surface 212.

In the example shown, microtube 202 has an outer diameter OD and an inner diameter ID. In some examples, OD may be equal to or less than 10 mm, or equal to or less than 5 mm, or equal to or less than 3 mm, or equal to or less than 1 mm. Inner diameter ID may be equal to outer diameter ID minus a value equal to twice a thickness of tube wall 206. In some examples, tube wall 206 may have a thickness of from about 0.05 mm to about 3 mm. In the example shown, first dimple 204a has a surface height variation h. As described above, h may be a recess into tube wall 206 or a protrusion from tube wall 206 from one or both of inner surface 214 and outer surface 212. In some examples, h may be a surface height variation from one or both of inner surface 214 and outer surface 212 that is equal to or greater than five per cent (5%) of the outer diameter OD of microtube 202. In some examples, h may be a surface height variation from one or both of inner surface 214 and outer surface 212 that is equal to or less than 15% of the outer diameter D of the microtube 202.

In the example shown, dimple 204 may have any suitable cross-sectional shape, e.g., a square shape, a circular shape, an elliptical shape, a polygonal shape, or the like. In the example shown, dimple 204 comprises a curved surface height variation having a maximum radius of curvature R that is 0.050 inches (e.g., 50 mils, or about 1.25 mm). Although microtube 202 is shown having first dimple 204a and second dimple 204b, microtube 202 may further include a plurality of dimples (collectively, dimples "204"), where each dimple 204 may have any of the geometries described above and each dimple 204 may be different than other dimples 204 of the plurality of dimples 204, e.g., first dimple 204a may be a protrusion into lumen 208 from inner surface 214, and a second dimple 204b may be a recess into tube wall 206 from lumen 208. In the example shown, dimple 204 is circumferential about microtube 202. In other examples, dimple 204 may extend only partially about the circumference of microtube 202.

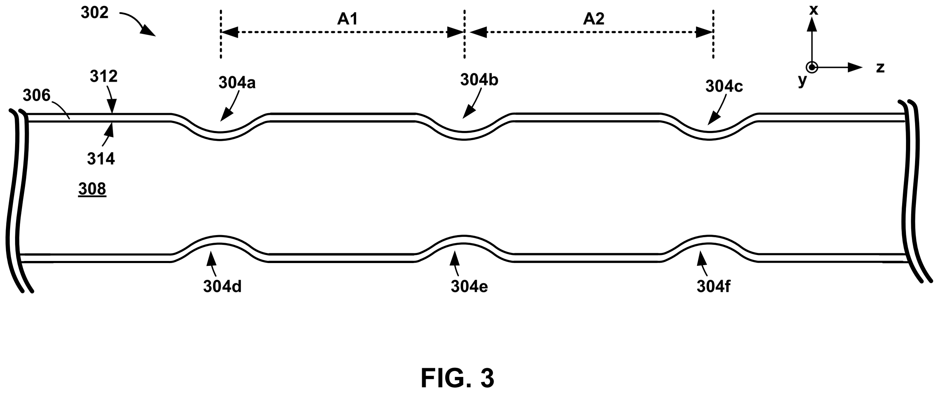

FIG. 3 is a cross-sectional side view of an example dimpled tube 302 for use with a heat exchanger, in accordance with examples of the present disclosure. Dimples tube 302 may be a microtube for use in heat exchanger 100, and thus may be an example of microtube 202 of FIG. 2. Dimpled tube 302 includes tube wall 306 which defines outer surface 312, inner surface 314, and lumen 308. Dimpled tube 302 further defines plurality of dimples 304 which include first dimple 304a, second dimple 304b, third dimple 304c, fourth dimple 304d, fifth dimple 304e, and sixth dimple 304f.

In some examples, dimpled tube may define a substantially circular outer perimeter. Plurality of dimples 304 may be uniformly distributed along a length and/or about a circumference of dimpled tube 302 to enable increased mixing of fluid flowing through lumen 308 without unnecessarily increasing a pressure drop of the fluid flowing along the length first dimple 304a may be axially displaced from second dimple 304b by first axial distance A1. Second dimple 304b may be axially displaced from third dimple 304c by second axial distance A2. In some examples, first axial distance A1 may be equal to second axial distance A2. Such an arrangement, where plurality of dimples 304 are uniformly distributed along a length of dimpled tube 302, may advantageously maintain turbulent flow of a fluid within lumen 308 without increasing a pressure drop along the length of dimpled tube 302 by more than a threshold pressure drop.

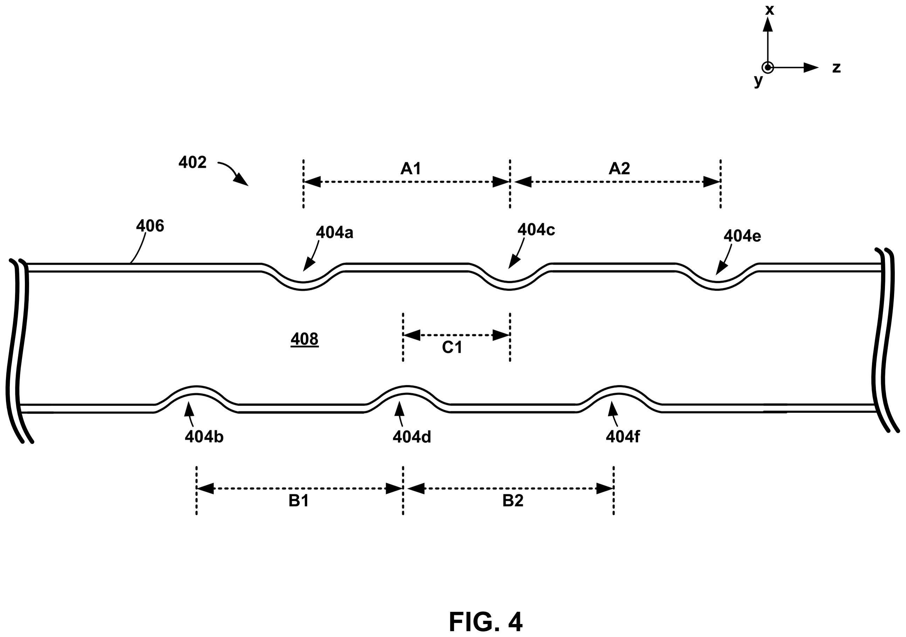

In some cases, as illustrated, first dimple 304a may be opposite a corresponding dimple (e.g., fourth dimple 304d) on an opposite side (e.g., separated by 180°) of dimpled tube 302 at a same axial position. Such an arrangement may increase mixing, turbulent flow, and thus increase the transfer of thermal energy from the first fluid flowing within lumen 308 to the second fluid positioned outside dimpled tube 302. Alternatively, as shown in FIG. 4, dimples 404a, 404b, 404c positioned along a length of dimpled tube 402 at a first circumferential position, may be opposite (e.g., 180° displaced from) dimples 404b, 404d, 404f positioned along the length of dimpled tube 402 at a second circumferential position.

Dimple 404a may be displaced from dimple 404c by axial distance A1, and dimple 404c may be displaced from dimple 404e by axial distance A2. As described above, axial distance A1 may be equal to axial distance A2. The dimples arranged circumferentially opposite may be arranged similarly, such that dimple 404b is displaced from dimple 404d by axial distance B1, and dimple 404d is displaced from dimple 404f by axial distance B2. Axial distance B1 may be equal to axial distance B2 and to axial distance A1. In some examples, plurality of dimples 404 may be arranged such that dimple 404d is axially displaced from dimple 404c by axial distance C1. Distance C1 may be equal to half of axial distance A1. In this way, plurality of dimples 404 may be arranged such that a dimple is located on an opposite side of tube wall 406 across lumen 408 between each adjacent dimple at a first circumferential position, which may enable increased turbulent flow inside dimpled tube 402.

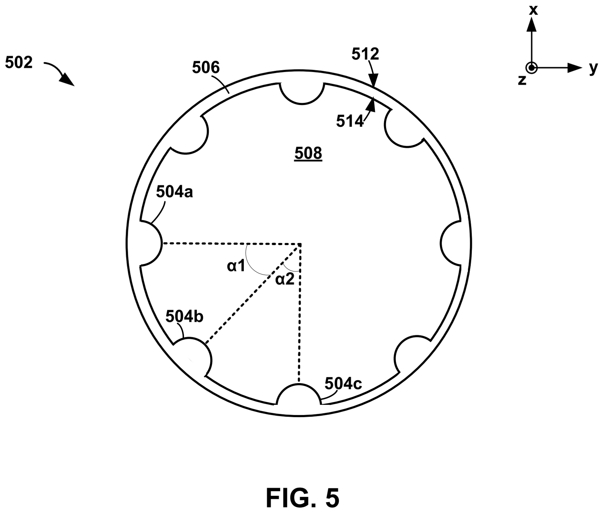

FIG. 5 is a cross-sectional longitudinal view of an example dimpled tube 502. Dimpled tube 502 may be an example of any of the microtubes described above, and may be suitable for used in heat exchanger 100 of FIG. 1. Dimpled tube 502 include tube wall 506 which defines outer surface 512 and inner surface 514. Inner surface 514 defines lumen 508.

Dimpled tube 502 defines plurality of dimples 504 which includes first dimple 504a, second dimple 504b, and third dimple 504c. Plurality of dimples 504 may be arranged about the circumference of dimpled tube 502 such that first dimple 504a is displaced from second dimple 504b by first angle α1, and second dimple 504b is displaced from third dimple 504c by second angle α2. In some examples, first angle α1 may be equal to second angle α2. In this way, plurality of dimples 504 may be uniformly distributed about the circumference of dimpled tube 502, which may promote increased turbulent flow of fluid within lumen 508 while minimizing an increase in a pressure drop. In some examples, angle α1 may be in a range of from about 5° to about 180°, such as from about 10° to about 90°.

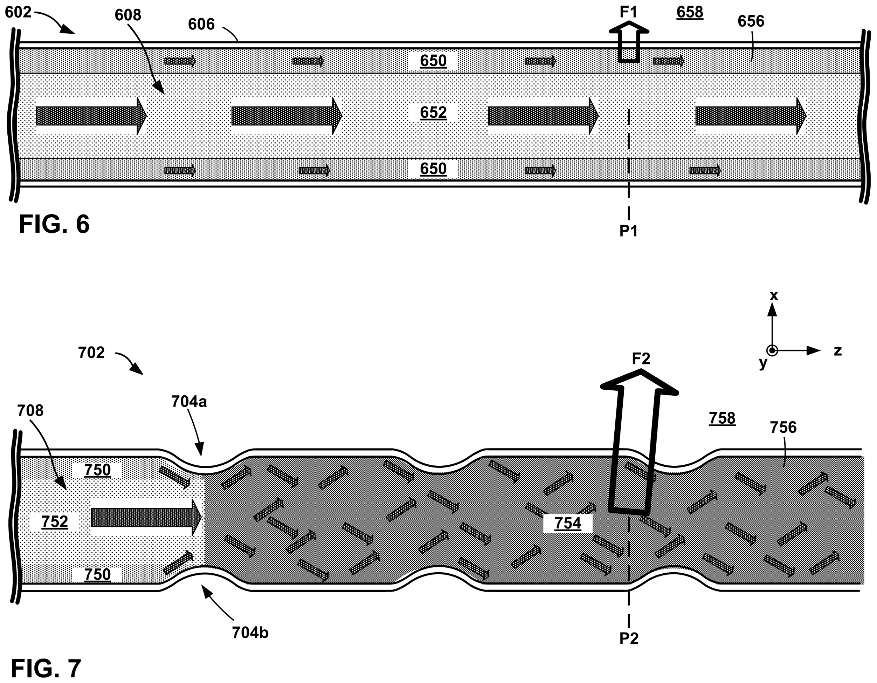

FIG. 6 is a cross-sectional side view of an example non-dimpled microtube 602 with a first fluid 656 flowing through lumen 608 and a second fluid 658 surrounding the microtube. Non-dimpled microtube 602 is illustrated from comparison to dimpled microtubes according to the present disclosure. The smooth inner and outer surfaces of non-dimpled microtube 602 may promote formation of a boundary layer 650 of first fluid 656 flowing in a laminar flow state near tube wall 606, and a bulk flow 652 of first fluid 656 flowing in a central region of lumen 608. As first fluid flow along the axial length of non-dimpled tube 602 as shown by the arrows, the reduced flow rate and poor mixing of boundary layer 650 may result in boundary layer cooling more than bulk region 652. As such, boundary layer 650 may reduce a driving force for heat flux from first fluid 656 to second fluid 658, resulting in first heat flux F1 at axial position P1.

FIG. 7 is a cross-sectional side view of an example dimpled microtube 702 with a first fluid 756 flowing through lumen 708 and a second fluid 758 surrounding dimpled microtube 702. Dimpled microtube 702 may be generally described similarly to non-dimpled microtube 602 of FIG. 6, except dimpled microtube 702 defines a plurality of dimples including first dimple 704a and second dimple 704b, while non-dimpled microtube 602 of FIG. 6 defines smooth tube wall 606. FIG. 7 illustrates operation of a heat exchanger that includes a dimpled microtube in accordance with the present disclosure. First fluid 756 may flow through lumen 708, forming boundary layer 750 and bulk region 752, as described above. However, first dimple 704a and second dimple 704b may protrude into lumen 708, disrupting boundary layer 750 and resulting in turbulent flow zone 754. Turbulent flow zone 754 may promote an increased rate of heat transfer from first fluid 756 to second fluid 758. For example, at point P2, which is a similar point along a length of dimpled microtube 702 as point P1 is along non-dimpled microtube 602 of FIG. 6, thermal energy may be transferred from first fluid 756 to second fluid 758 at heat flux F2. Heat flux F2 from dimpled microtube 702 may be greater than heat flux F1 from non-dimpled microtube 602. Thus, plurality of dimples 704 may promote increased efficiency of heat transfer within a heat exchanger through increased turbulent flow of first fluid 756 and/or second fluid 758.

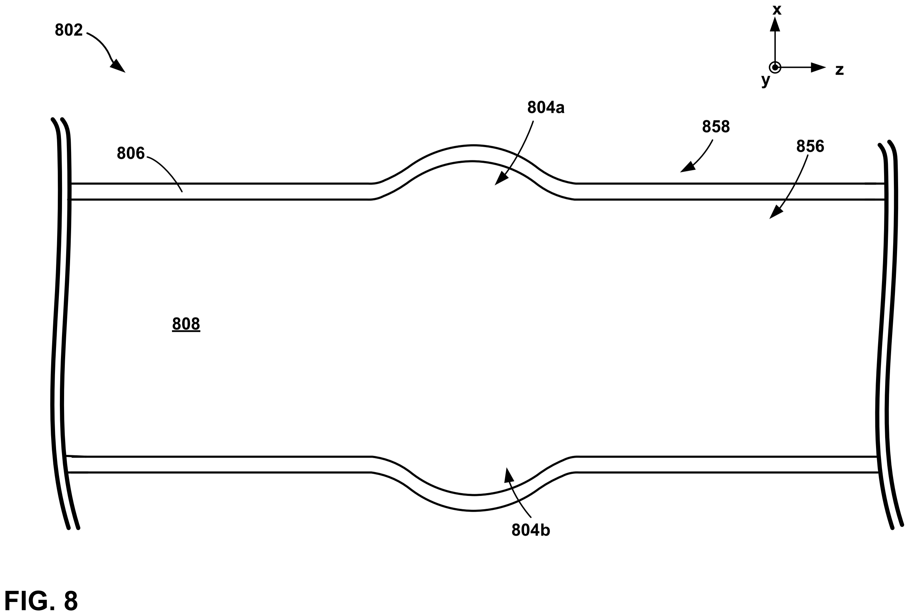

FIG. 8 is a cross-sectional side view of an example dimpled microtube 802 for use with a heat exchanger, in accordance with examples of the present disclosure. Dimpled microtube 802 may be an example of any of the dimpled microtubes described herein. Dimpled microtube 802 may include tube wall 806 which defines lumen 808. First fluid 856 may flow through lumen 808, while second fluid 858 may flow along or around dimpled microtube 802. Tube wall 806 may define plurality of dimples 804 which include first dimple 804a and second dimple 804b. In some cases, as illustrated, at least one of first dimple 804a or second dimple 804b may define a height variation which protrudes from tube wall 806 into second fluid 858 (e.g., away from lumen 808. Similar to dimples which define a height variation that protrudes into the lumen, first dimple 808a and second dimple 808b may promote turbulent flow and thus increased heat transfer from the first fluid to the second fluid by disrupting the formation of a boundary layer in first fluid 856 and second fluid 858.

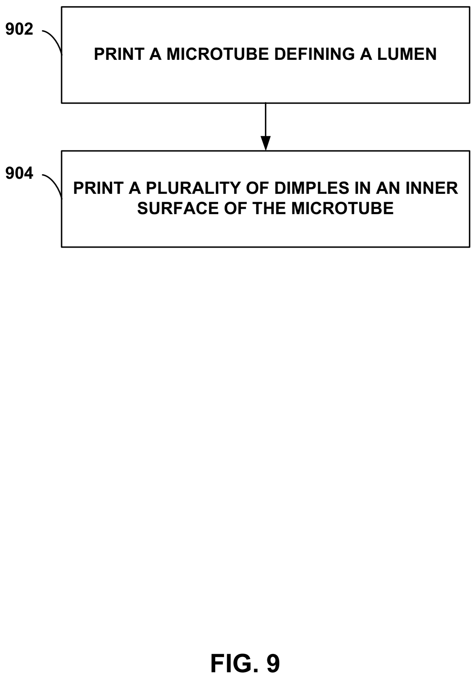

FIG. 9 is a flowchart of an example method of making a microtube, in accordance with examples of the present disclosure. FIG. 3 is described with reference to microtube 202 of FIG. 2 and heat exchanger 100 of FIG. 1.

A printer may print microtube 202 defining lumen 208 and comprising inner surface 214 and an outer surface 212 of tube wall 206 (902). For example, a 3D printer may be used to print microtube 202. The printer may print microtube 202 with an outer diameter D of equal to or less than 10 mm, or equal to or less than 5 mm, or equal to or less than 3 mm, or equal to or less than 1 mm. In some examples, printing microtube 202 may include depositing a first volume of material, and subsequent to depositing the first volume of material, depositing a second volume of material. In some examples, printing microtube 202 may include cooling the first volume of material to harden the first volume of material prior to depositing the second volume of material. Cooling the first volume of material may include controlling a cooling rate of the first volume of material.

The printer may print a plurality of dimples 204 in the inner surface 214 of the microtube 202 (904). In some examples, the printer may print the plurality of dimples 204 alternatively or additionally in outer surface 212 of microtube 202, and/or with any of the dimple 204 geometries described above. In some examples, a 3D printer may print each dimple 204 of the plurality of dimples 204. In some examples, the printer may print dimples 204 configured to cause a turbulent flow of a fluid 120 within the lumen 208 of the microtube 202. In some cases, printing microtube 202 and printing plurality of dimples 204 may occur simultaneously, such that dimpled microtube 202 may be additively-manufactured in one piece.

Example 1: A heat exchanger includes a microtube defining a lumen and including a plurality of dimples configured to cause a turbulent flow of a fluid within the lumen of the microtube, wherein the microtube has an outer diameter equal to or less than 5 millimeters (mm).

Example 2: The heat exchanger of example 1, wherein the fluid within the lumen of the microtube is a first fluid comprising an oil, wherein the heat exchanger is configured to allow a second fluid to flow in contact with an external surface of the microtube.

Example 3: The heat exchanger of example 2, wherein the second fluid is air.

Example 4: The heat exchanger of any of examples 1 through 3, wherein the microtube comprises a tube wall defining the lumen, the tube wall comprising an inner surface and an outer surface external to the lumen, wherein each dimple of the plurality of dimples comprises a height variation of the inner surface of the microtube.

Example 5: The heat exchanger of example 4, wherein the height variation comprises a dimple depth of equal to or greater than five per cent (5%) of the outer diameter of the microtube.

Example 6: The heat exchanger of example 5, wherein the dimple depth is equal to or less than 15% of the outer diameter of the microtube.

Example 7: The heat exchanger of any of examples 1 through 6, wherein the microtube comprises a tube wall defining the lumen, the tube wall comprising an inner surface and an outer surface external to the lumen, wherein each dimple of the plurality of dimples comprises a height variation of the outer surface of the microtube.

Example 8: The heat exchanger of any of examples 1 through 7, further comprising a plurality of microtubes configured to have a spacing between respective outer surfaces of adjacent microtubes of 3 mm or less.

Example 9: The heat exchanger of any of examples 1 through 8, wherein the plurality of dimples are uniformly distributed along a length of the microtube.

Example 10: The heat exchanger of example 9, wherein: the plurality of dimples includes a first dimple, a second dimple, and a third dimple, the first dimple is displaced from the second dimple by a first axial distance, the second dimple is displaced from the third dimple by a second axial distance, and the first axial distance is equal to the second axial distance.

Example 11: The heat exchanger of any of examples 1 through 10, wherein the plurality of dimples are uniformly distributed about a circumference of the microtube.

Example 12: The heat exchanger of any of examples 11 and 12, wherein: the microtube defines a substantially circular outer perimeter, the plurality of dimples includes a first dimple, a second dimple, and a third dimple, the first dimple is displaced from the second dimple by a first angle, the second dimple is displaced from the third dimple by a second angle, and the first angle is equal to the second angle.

Example 13: The heat exchanger of any of examples 4 through 12, wherein the plurality of dimples are configured to increase mixing of the fluid flowing with the lumen by disturbing a boundary layer of the fluid relatively near the tube wall.

Example 14: The heat exchanger of any of examples 12 and 13, wherein the increased mixing of the fluid is configured to increase a rate of transfer of thermal energy from the fluid.

Example 14: The heat exchanger of any of examples 1 through 14, wherein a first dimple of the plurality defines at least a portion of a circular cross-section.

Example 16: The heat exchanger of any of examples 14 and 15, wherein the circular cross-section defines a radius of curvature of less than or equal to 1.25 millimeters.

Example 17: A method of making a microtube includes printing a microtube defining a lumen, the microtube comprising an inner surface and an outer surface; and printing a plurality of dimples in the inner surface of the microtube, each dimple of the plurality of dimples being configured to cause a turbulent flow of a fluid within the lumen of the microtube, and wherein an outer diameter of the microtube is equal to or less than 5 millimeters (mm).

Example 18: The method of example 17, wherein printing the microtube comprises depositing a first volume of material, and subsequent to depositing the first volume of material, depositing a second volume of material.

Example 19: The method of any of examples 17 and 18, further comprising cooling the first volume of material to harden the first volume of material prior to depositing the second volume of material.

Example 20: The method of any of examples 18 and 19, wherein cooling the first volume of material comprises controlling a cooling rate of the first volume of material.

Example 21: The method of any of examples 16 through 20, wherein printing the microtube and printing the plurality of dimples occur simultaneously.

Various examples have been described. These and other examples are within the scope of the following claims.

## Claims

1. A heat exchanger comprising:
a microtube defining a lumen and including a plurality of dimples configured to cause a turbulent flow of a fluid within the lumen of the microtube,
wherein the microtube has an outer diameter equal to or less than 5 millimeters (mm).

2. The heat exchanger of claim 1, wherein the fluid within the lumen of the microtube is a first fluid comprising an oil, wherein the heat exchanger is configured to allow a second fluid to flow in contact with an external surface of the microtube.

3. The heat exchanger of claim 2, wherein the second fluid is air.

4. The heat exchanger of any of claims 1-3, wherein the microtube comprises a tube wall defining the lumen, the tube wall comprising an inner surface and an outer surface external to the lumen, wherein each dimple of the plurality of dimples comprises a height variation of the inner surface of the microtube.

5. The heat exchanger of claim 4, wherein the height variation comprises a dimple depth of equal to or greater than five per cent (5%) of the outer diameter of the microtube.

6. The heat exchanger of claim 5, wherein the dimple depth is equal to or less than 15% of the outer diameter of the microtube.

7. The heat exchanger of any of claims 1-6, wherein the microtube comprises a tube wall defining the lumen, the tube wall comprising an inner surface and an outer surface external to the lumen, wherein each dimple of the plurality of dimples comprises a height variation of the outer surface of the microtube.

8. The heat exchanger of any of claims 1-7, further comprising a plurality of microtubes configured to have a spacing between respective outer surfaces of adjacent microtubes of 3 mm or less.

9. The heat exchanger of any of claims 1-8, wherein the plurality of dimples are uniformly distributed along a length of the microtube.

10. The heat exchanger of claim 9, wherein:
the plurality of dimples includes a first dimple, a second dimple, and a third dimple,
the first dimple is displaced from the second dimple by a first axial distance,
the second dimple is displaced from the third dimple by a second axial distance, and
the first axial distance is equal to the second axial distance.

11. The heat exchanger of any of claims 1-10, wherein the plurality of dimples are uniformly distributed about a circumference of the microtube.

12. The heat exchanger of claim 11, wherein:
the microtube defines a substantially circular outer perimeter,
the plurality of dimples includes a first dimple, a second dimple, and a third dimple,
the first dimple is displaced from the second dimple by a first angle,
the second dimple is displaced from the third dimple by a second angle, and
the first angle is equal to the second angle.

13. The heat exchanger of any of claims 4-12, wherein the plurality of dimples are configured to increase mixing of the fluid flowing with the lumen by disturbing a boundary layer of the fluid relatively near the tube wall.

14. The heat exchanger of claim 13, wherein the increased mixing of the fluid is configured to increase a rate of transfer of thermal energy from the fluid.

15. A method of making a microtube, the method comprising:
printing a microtube defining a lumen, the microtube comprising an inner surface and an outer surface; and
printing a plurality of dimples in the inner surface of the microtube, each dimple of the plurality of dimples being configured to cause a turbulent flow of a fluid within the lumen of the microtube, and
wherein an outer diameter of the microtube is equal to or less than 5 millimeters (mm).
